# FASCICULE DE BREVET EUROPEEN

(11) **EP 0 574 286 B1**
(45) Date de publication et mention de la délivrance du brevet: **15.10.1997**
(21) Numéro de dépôt: 93401369.9
(22) Date de dépôt: 28.05.1993
(51) Int. Cl.: H05K 7/14, H05K 5/00

(54) **Procédé d'assemblage par collage sous vide des circuits hybrides**
Methode zur Montage von Hybridschaltungen durch Vakuum-Verklebung
Method for assembling hybrid circuits by vacuum bonding

(30) Priorité: 02.06.1992 FR 9206653
(43) Date de publication de la demande: 15.12.1993
(73) Titulaire: ALCATEL ALSTHOM COMPAGNIE GENERALE D'ELECTRICITE, 75008 Paris (FR)
(72) Inventeur: Naudin, Paul, F-31270 Cugnaux (FR); Hancali, Stephane, F-31750 Escalquens (FR)
(74) Mandataire: Pothet, Jean Rémy Emile Ludovic

(56) Documents cités:
- WO-A-90/09090
- US-A- 4 100 589

## Description

Le domaine technique de l'invention est celui de l'assemblage des circuits microélectroniques, plus particulièrement celui de l'assemblage des circuits dits "couches minces" réalisés sur substrat rigide. De tels circuits sont utilisés notamment en hyperfréquence, car des lignes de transmission hyperfréquence peuvent être facilement réalisées en cette technologie par simple gravure d'un chemin électrique sur une face d'un substrat diélectrique, formant une ligne de transmission avec l'autre face du substrat, qui sera entièrement métallisée et tenue à la masse. Des composants actifs ou passifs sont ensuite rapportés sur ces circuits, formant des sous-ensembles électroniques pour remplir des fonctions hyperfréquence. De tels circuits sont connus sous le nom circuits hybrides.

Dans des applications pratiques, plusieurs de ces sous-ensembles sont souvent nécessaires pour accomplir les missions d'un équipement donné. Il devient nécessaire dans ces cas de réaliser des interconnexions entre les sous-ensembles qui sont les circuits hybrides, ce qui demande des lignes de transmission (coaxial, guide, triplaque,...) et de la connectique entre ces lignes et celles formées sur les substrats de ces circuits. D'autre part, ces circuits doivent être fixés mécaniquement dans l'équipement, et un chemin pour l'évacuation de calories provenant des éléments dissipatifs sur le circuit doit être fourni en minimisant la résistance thermique de celui-ci. Il en résulte que la conception de ces sous-ensembles repose largement sur les contraintes imposées par leur environnement pour réussir leur intégration dans un équipement : les connexions mécaniques, thermiques et électroniques entre circuits hybrides d'un même équipement, et entre les circuits et leur support mécanique dans l'équipement, deviennent des critères prépondérants dans la conception de ces circuits. Ainsi, pour l'optimisation d'un équipement, le concepteur est amené à optimiser toutes ces connexions.

L'une des directions explorées pour optimiser ces connexions contraignantes est d'en minimiser le nombre c'est-à-dire de maximiser le nombre de fonctions hyperfréquence qui peuvent être intégrées sur un seul substrat, afin de minimiser le nombre de substrats nécessaires pour réaliser un équipement donné. Après avoir optimisé la densité d'intégration possible sur un seul substrat, on peut chercher aussi à augmenter la taille du substrat pour pouvoir y intégrer le maximum de composants et de fonctions. La réduction du nombre de substrats a pour effet de réduire l'encombrement et le poids des équipements, un effet particulièrement recherché dans le domaine spatial par exemple.

Mais il existe des obstacles à la course à l'intégration sur des substrats des circuits hybrides en couches minces. Ces circuits sont généralement réalisés sur une plaque diélectrique en Al₂O₃ (l'alumine), qui est un diélectrique céramique rigide. En conséquence, il est nécessaire de pouvoir assurer que les circuits fragiles qui seront réalisés sur ces substrats fragiles, résisteront aux rigueurs et aux épreuves de l'environnement dans lequel l'équipement devra fonctionner. En particulier, pour le moment, ces circuits hyperfréquence sont utilisés, pour la plupart, dans des applications militaires et/ou spatiales ; deux domaines d'activité où l'environnement est particulièrement sévère et hostile, et où la fiabilité de l'équipement doit être quasi-parfaite malgré cet environnement hostile.

Pour ces raisons, jusqu'alors, la taille maximale des circuits hybrides sur substrat d'alumine pour de telles applications a été limitée à un pouce par deux (1'' X 2'' = 2.5 X 5 cm environ), notamment pour la résistance aux chocs et vibrations. Pour des substrats plus grands, on n'arrive plus, dans l'état de l'art, à assurer l'intégrité du circuit avec une fiabilité et une marge de sécurité suffisantes, dans des conditions hostiles de l'utilisation dans un équipement embarqué (sur satellite ou sur plateforme militaire : camion, navire, missile, char, aéronef...).

De plus, pour assurer l'évacuation thermique de la chaleur produite par les composants actifs du circuit hybride, ainsi que la résistance mécanique d'un substrat de cette taille, il est souvent nécessaire de recourir à un renforcement du substrat, qui sera rapporté sur un cadre métallique, ou encore, sur une plaque métallique. Ceci peut être effectué par exemple par brasure dure (forte teneur en argent). Ce procédé introduit d'autres limitations sur la taille maximale de réalisations, car la dilatation thermique différentielle entre le substrat, le cadre ou la plaque métallique, et la brasure elle-même peut donner lieu à une contrainte mécanique insupportable au-delà d'une certaine taille des éléments. De ce fait, la brasure sur cadre métallique qui peut encore être utilisée sur des réalisations de petite taille, demeure un procédé de mise en oeuvre difficile et coûteux. De plus, ce procédé n'est pas évalué pour l'assemblage de grandes surfaces (2" X 2" ou plus), et il semble qu'il serait très difficile sinon impossible de réaliser des assemblages ayant les caractéristiques électriques, thermiques, et mécaniques voulues, de cette taille ou de taille plus grande, par brasage dur.

Le document WO-A-90/09090 décrit un procédé pour l'assemblage d'un substrat de circuit électronique sur un support. Dans le procédé décrit, un cordon de colle est déposé sur l'une des deux pièces, puis le vide est fait entre les deux pièces de façon à écraser la colle et obtenir un film adhésif d'épaisseur uniforme.

Il est également connu, pour l'assemblage de circuits hybrides de petite taille sur support métallique, d'appliquer un procédé de collage. Dans un tel procédé de collage connu de l'art antérieur, une colle est placée entre les pièces à coller, et l'assemblage est ensuite serré mécaniquement dans un étau, un serre-joint ou similaire pendant le durcissement de la colle. De ce fait, les assemblages sont obligatoirement traités à l'unité, et les dimensions des pièces à assembler doivent rester petites pour permettre une efficacité et une uniformité de pression suffisante des moyens mécaniques qui doivent serrer les pièces ensemble lors du collage. Pour des pièces plus grandes, les points de force mécanique appliquée sur les pièces à assembler peuvent conduire à un collage imparfait, ayant une épaisseur non-uniforme ou avec des inclusions ou des poches d'air, sinon à briser la céramique du substrat.

L'un des buts de l'invention est de pallier les limitations de l'art antérieur pour ce qui est la taille maximale des circuits réalisables, sans toutefois compromettre ni leur fiabilité ni leur robustesse. Ce faisant, l'encombrement et le poids des équipements peuvent être diminués, de même que le nombre des lignes et d'interconnexions entre les substrats de circuits hybrides de différents sous-ensembles de l'équipement. Par rapport aux solutions connues pour les assemblages de plus petite taille, l'invention cherche à en diminuer les coûts de fabrication et les difficultés de mise en oeuvre, tout en assurant des rendements de fabrication et des performances mécaniques meilleures. En outre, le procédé selon l'invention permet d'obtenir un assemblage sans inclusions de poches d'air, ce qui améliore la conductivité thermique et électrique et la résistance mécanique de l'ensemble ainsi réalisé.

L'invention est définie dans la revendication 1.

De fait, on connaît dans un autre domaine technique très éloigné de celui de la présente demande, celui de l'assemblage des matériaux composites pour fabriquer des pièces ayant des grandes dimensions et des surfaces complexes, une technique de collage faisant appel à la pression atmosphérique pour serrer des couches laminées successives. Ce procédé de collage est utilisé par exemple pour assembler des feuilles ou des tissus de matériaux synthétiques dans la fabrication d'objets tels des coques de bateaux, des skis, la carrosserie d'engins, des réflecteurs d'antennes, des pare-chocs, ailes ou capots de voitures de sport, des planches à voile, ... . Le procédé selon l'invention peut avantageusement mettre à profit une caractéristique d'une technique provenant de ce domaine éloigné de celui de l'invention.

Ainsi, selon une caractéristique importante du procédé d'assemblage de circuits hybrides selon l'invention, ladite pression mécanique est obtenue en établissant un différentiel de pression atmosphérique entre une première et une deuxième régions séparées de façon étanche par au moins une paroi souple, ladite première région contenant lesdites pièces à assembler, ladite deuxième région contenant entièrement ladite première région, ladite première région étant mise en sous pression par rapport à ladite deuxième région. Pour simplifier la discussion qui suit, on dénommera un tel procédé par le terme générique : "collage sous vide".

Selon une variante préférée du procédé selon l'invention, lesdites pièces à assembler sont placées sur une surface rigide ayant des dimensions plus grandes que les dimensions des pièces à assembler. Les pièces à assembler sont ensuite recouvertes d'une feuille d'un matériau souple et imperméable à l'air, et ladite feuille est jointe de façon étanche à ladite surface rigide, autour des pièces à assembler, de façon à former avec la surface rigide une première région entre la feuille et la surface rigide. Cette première région contient donc les pièces à assembler, et elle est ainsi séparée de façon étanche d'une deuxième région en dehors de ladite première région et contenant entièrement cette première région. Ensuite, la première région est au moins partiellement évacuée à l'aide d'une pompe à vide mise en communication avec l'intérieur de cette région par une canalisation étanche. La pression atmosphérique qui règne dans la deuxième région tout autour de ladite première région évacuée, exerce ainsi une pression mécanique uniforme sur les pièces à assembler, à travers ladite surface rigide, d'une part, et ladite feuille d'un matériau souple, d'autre part.

Selon une caractéristique préférentielle de l'invention, ladite surface rigide aura des dimensions plus grandes qu'un multiple des dimensions des pièces à assembler, de façon à pouvoir mettre plusieurs paires de pièces à assembler sur ladite surface rigide pour effectuer le collage sous vide de plusieurs assemblages simultanément.

Selon une autre caractéristique préférentielle du procédé selon l'invention, ledit substrat rigide est métallisé sur au moins l'une de ses deux faces, et ledit film de colle est placé en contact avec la face ainsi métallisée du substrat. Avantageusement, ladite deuxième pièce métallique aura un coefficient de dilatation thermique voisin de celui dudit substrat rigide, de façon à minimiser les contraintes mécaniques dues à une dilatation différentielle lors d'excursions en température.

Dans une réalisation préférée selon le procédé de l'invention, ledit substrat est de l'alumine (Al₂O₃). Dans ce cas, avantageusement, ladite deuxième pièce métallique sera de l'alliage "Dilver", nom de commerce bien connu de l'homme de l'art. Selon une autre caractéristique préférentielle du procédé de l'invention, la matière de ladite surface rigide sera choisie pour avoir le même coefficient de dilatation thermique que ladite deuxième pièce mécanique, et sera le plus souvent réalisé en cette même matière.

Selon d'autres caractéristiques préférentielles de l'invention, ladite colle sera conductrice, soit thermiquement, soit électriquement, soit les deux.

Selon une autre caractéristique importante de l'invention, des trous seront aménagés à travers le substrat rigide, dans lesquels des plots conducteurs seront posés et scellés avec de la même colle. Ces plots permettent ainsi de traverser le substrat par un chemin électriquement conducteur, pour former un retour à la masse par exemple.

Avantageusement, ledit film de colle comprendra une trame d'un matériau relativement incompressible, de façon à tenir les deux pièces à assembler à une distance minimale lors de la polymérisation, même avec un fort différentiel de pression. Cette trame pourrait être un tissu de fibres de verre, selon une réalisation préférée de l'invention. Ainsi, ledit film de colle pourrait être réalisé par un tissu de fibres de verre, imprégné d'une colle appropriée.

Finalement, l'invention concerne tous les dispositifs d'assemblages de circuits qui seront réalisés selon les principes de l'invention et de ses caractéristiques essentielles.

Des essais en laboratoire ont permis de confirmer le procédé selon l'invention pour des circuits hybrides sur substrats céramiques rigides, d'une taille d'au moins deux fois plus grande que celles utilisées couramment dans l'art antérieur, c'est-à-dire 2'' X 2'' (5 X 5 cm environ), et ceci dans des essais d'environnement sévère allant jusqu'à des accélérations au-delà de 70 G. Ces performances sont réalisées sans augmentation pour autant des coûts de fabrication ni des difficultés de mise en oeuvre. Au contraire, le procédé selon une variante de l'invention permet la réalisation simple de plusieurs assemblages en même temps, et avec un taux de réussite bien supérieur à celui que l'on retrouve habituellement dans des procédés utilisant la brasage. Le rendement de fabrication est ainsi largement amélioré par rapport aux procédés connus de l'art antérieur, tout en diminuant les coûts et avec des performances meilleures. De plus, l'encombrement et le poids de l'équipement final peuvent être réduits sans inconvénient en contrepartie. Finalement, le procédé selon l'invention sera facilement qualifié pour le spatial, car les propriétés des matériaux qui rentrent dans le procédé sont bien caractérisées pour leur comportement au lancement et en orbite.

D'autres caractéristiques et avantages de l'invention ressortiront lors de la description détaillée de quelques exemples non-limitatifs qui suit, avec ses figures annexées sur lesquelles :
- la figure 1 représente schématiquement en perspective et en éclaté un procédé d'assemblage de circuits hybrides par brasure sur cadre métallique selon l'art antérieur ;
- la figure 2 représente schématiquement en perspective et en éclaté un exemple simplifié d'un procédé selon l'invention d'assemblage d'un circuit hybride sur une pièce métallique par collage sous vide ;
- la figure 3 représente schématiquement en plan un exemple selon le procédé de l'invention, d'assemblage de plusieurs circuits hybrides sur plusieurs pièces métalliques en une seule opération industrielle ;
- la figure 4 représente schématiquement et en coupe un dispositif de circuit hybride collé sur son support métallique réalisé par le procédé de l'invention ;
- la figure 5 représente schématiquement et en coupe une variante d'un dispositif réalisé selon le principe de l'invention, ayant deux substrats de deux circuits hybrides collés sur la même face d'une seule pièce métallique faisant support ;

Sur toutes les figures, les mêmes références indiquent les mêmes éléments ; cependant les dimensions relatives ne sont pas toujours respectées afin d'améliorer la clarté des dessins.

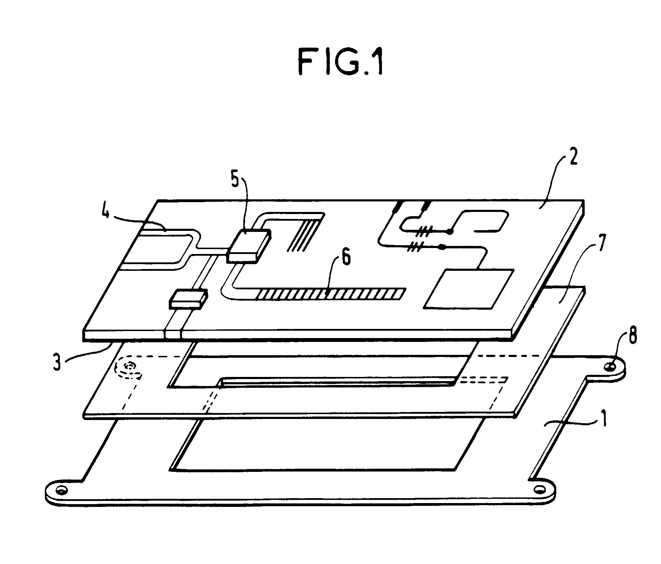

Sur la figure 1 l'on voit un exemple d'un procédé d'assemblage de circuits hybrides sur un support métallique par brasure dure selon une méthode connue de l'art antérieur. Le circuit électronique, montré de façon très schématique, comprend sur un substrat diélectrique (2) généralement réalisé en céramique avec une métallisation (3) sur une première de ses deux faces, des composants actifs (5) et passifs (6) reliés par des pistes conductrices (4) réalisées par photogravure ou tout autre procédé sur la deuxième face du substrat (2) et formant des lignes de transmission par rapport à la métallisation (3) tenue à la masse et séparée des pistes conductrices et les éléments du circuit par le substrat diélectrique (2). Pour obtenir une meilleure conductivité électrique et thermique de l'ensemble, la métallisation est le plus souvent en or, mais d'autres matériaux peuvent être envisagés.

Selon le procédé de l'art antérieur, le substrat (2) est rapporté sur un support métallique (1) par brasure entre la face métallisée (3) du substrat (2) et le support (1). Dans l'exemple de la figure 1, le support (1) a la forme d'un cadre ; le support pourrait également avoir la forme d'une plaque métallique sans fenêtre au milieu. Pour effectuer la brasure, l'alliage de brasure (7), en général une préforme prédécoupée telle que montré sur la figure 1, est insérée entre le substrat (2) et le support (1) et en contact avec les faces à assembler de ces deux pièces. L'ensemble est ensuite chauffé à haute température, jusqu'au point de fusion de l'alliage de brasure. En général, la brasure utilisée pour l'assemblage de circuits hybrides est une brasure dure, et aura donc un point de fusion relativement élevé. Pour cette raison, il est préférable d'attendre que la brasure soit effectuée avant d'installer les éléments actifs sur le circuit, car ils peuvent être détruits par la haute température utilisée.

Le substrat (2) et le support (1) ont en général des dimensions latérales très voisines sinon identiques. Cependant, il est prévu, dans l'exemple de la figure 1, quatre trous de fixation (8) du circuit assemblé, disposés sur les quatre coins du support rectangulaire (1), dans des petites pattes de fixation faisant sailli dans le plan du support au-delà des dimensions du substrat (2).

Il est à noter que les dimensions maximales de réalisations connues, issues du procédé selon cet art antérieur, sont de 1 '' X 2 '', soit 2, 5cm x 5 cm environ. Il parait difficile sinon impossible d'étendre cette technologie vers des dimensions plus grandes, car les contraintes mécaniques provenant de la dilatation différentielle de la brasure dure, le substrat, et le support lors des excursions en température seront suffisantes pour briser la céramique du substrat ou le joint de brasure.

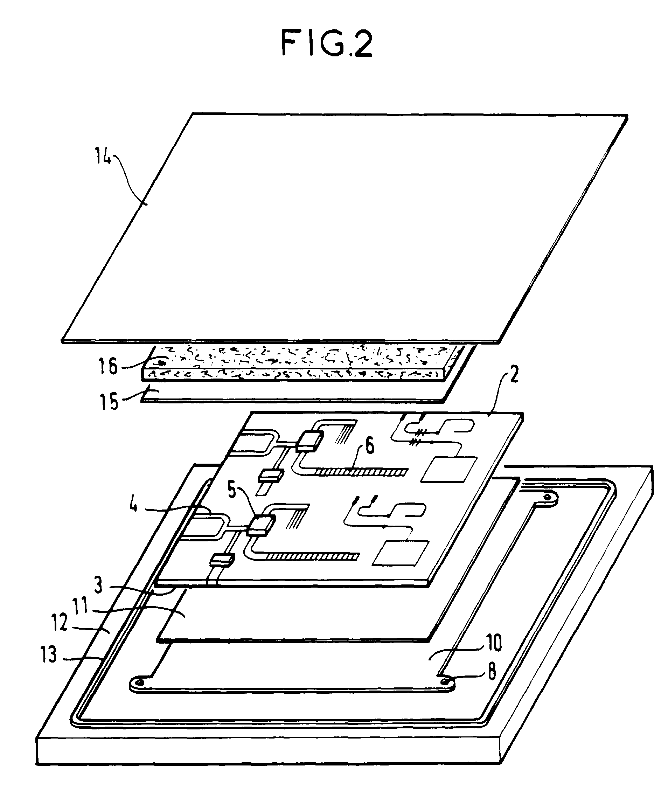

Sur la figure 2, l'on voit schématiquement en perspective et en éclaté, un exemple d'un procédé selon l'invention d'assemblage d'un circuit hybride sur un support métallique par collage sous vide. Le circuit hybride comporte les mêmes éléments que le circuit de l'art antérieur montré sur la figure 1, seulement la taille du circuit est deux fois plus grande dans cet exemple que dans le précédent. En effet, le procédé selon l'invention permet d'atteindre des tailles de substrat d'au moins deux fois plus grandes que possible dans l'art antérieur. Comme dans l'art antérieur, le substrat en céramique (2) comporte une métallisation (3) sur la première de ses deux faces, les composants actifs (5) et passifs (6) étant rapportés sur les pistes conductrices (4) sur la deuxième face du substrat.

Le substrat (2) sera assemblé sur un support (10) qui est une pièce métallique ayant des dimensions latérales voisines de celles du substrat, et sensiblement plan sur au moins sa surface supérieure sur laquelle le substrat (2) sera collé.

Dans le procédé selon l'invention, un film de colle (11) est inséré entre les deux surfaces planes à coller, à savoir : la surface supérieure du support (10) et la surface métallisée (3) du substrat (2). Le film de colle (11) est avantageusement découpé avec les mêmes dimensions latérales que le substrat (2) pour éviter des débordements importants de colle lors du procédé de polymérisation qui s'ensuivra.

Pour effectuer le procédé selon l'invention, un outillage simple sera nécessaire, dont un exemple est donné sur cette figure 2. Pour effectuer le collage sous vide, il faut aménager une première région étanche contenant les pièces à coller, pour pouvoir évacuer ladite première région. Une deuxième région existe tout autour de la première région évacuée, et cette deuxième région ne sera pas évacuée. En conséquence, la pression atmosphérique ambiante qui règne dans la deuxième région sera plus grande que la pression réduite à l'intérieur de la première région évacuée, et exercera une pression sur les parois de cette première région. Dans le procédé selon l'invention, cette pression sur les parois sera transmise sur les pièces à coller, comme nous le verrons par la suite.

Dans l'exemple d'outillage montré sur la figure 2, l'on voit une table rigide (12) ayant une surface supérieure très plane et des dimensions latérales plus grandes que les pièces à assembler. Sur le pourtour de cette surface, un joint d'étanchéité (13) est prévu, ayant lui aussi des dimensions latérales plus grandes que les pièces à assembler. Les pièces à assembler seront positionnées sur cette surface supérieure de cette table et empilées avec la précision de positionnement latéral voulue, à l'intérieur du joint (13). Le support (10) sera placé le premier sur la table (12), ensuite le film (11) de colle sera positionné sur la face supérieure dudit support (10), et ensuite le substrat (2) sera positionné sur le film (11), avec sa face métallisée (3) en contact avec ce film (11).

Pour fermer la première région à évacuer de façon étanche une paroi souple (14) est ensuite posée sur les pièces empilées à assembler, et vient en contact efficace avec le joint (13) d'étanchéité. La première région étanche est ainsi constituée, comprenant l'intérieur d'une enceinte étanche formée par la table (12), la paroi souple (14), et le joint d'étanchéité (13). Bien sur, pour évacuer cette première région, il faut prévoir une canalisation étanche (non-montrée) qui sera en communication avec l'intérieur de cette première région par l'une de ses extrémités, et raccordée à une pompe à vide (non-montrée) à son autre extrémité.

Dans l'exemple de la figure 2, l'on voit également quelques petites améliorations qui peuvent être apportées. Selon cet exemple, une feuille (15) de matériau souple et légèrement plus grande que les pièces à assembler est posée sur la surface supérieure du circuit hybride, et un feutre polyester (16) ayant les mêmes dimensions est posé sur cette feuille souple. La paroi souple (14) vient ensuite fermer la première région à évacuer. Le feutre (16) est prévu pour faciliter l'évacuation de cette première région, car des poches d'air éventuelles qui peuvent être formées à cause du relief de la surface supérieure du circuit, avec ses composants déjà en place, communiqueront avec le feutre, assurant ainsi une évacuation uniforme. La feuille (15) est pour protéger le feutre (16) des débordements éventuels de colle.

Après l'empilage des pièces à assembler avec le film de colle entre ces pièces, et après la fermeture étanche de la première région contenant ces pièces, cette région est évacuée à l'aide d'une pompe à vide. Une pression mécanique due au différentiel de pression ambiante qui règne à l'extérieur de l'enceinte avec celle, réduite, qui règne à l'intérieur de cette région évacuée s'exerce sur la table rigide (12) et la paroi souple (14) , qui s'appuient respectivement sur le support (10) et le substrat rigide (2). Cette force mécanique est ainsi appliquée et répartie uniformément sur toute la surface des pièces à assembler, dans une direction normale à la surface plane de chaque pièce, de façon à comprimer uniformément ledit film (11) de colle. L'ensemble peut être ensuite placé dans un four pour effectuer la polymérisation de la colle si la colle choisie est thermoactivée. La pression mécanique sera maintenue pendant toute la durée de la polymérisation de la colle en maintenant le vide dans la première région contenant les pièces à assembler, maintenant ainsi le différentiel de pression qui s'exerce sur ses parois.

Des essais du procédé de l'invention ont été effectués par la Déposante et ont donné des résultats satisfaisants pour différents choix de matériaux, et il apparait que des choix effectués parmi un vaste nombre de combinaisons seraient possibles sans pour autant sortir du cadre de l'invention. A titre d'exemple, le procédé de l'invention donne des résultats très satisfaisants, pour un circuit sur substrat (2) d'alumine (Al₂O₃), collé sur un support (10) en un alliage commercialisé sous la marque "Dilver" et bien connu de l'homme de l'art pour son coefficient de dilatation thermique très voisin de celui de l'alumine.

Pour des applications dans le domaine spatial, la Déposante a effectué des essais utilisant des éléments et des composants susceptibles d'une qualification rapide pour le spatial, c'est-à-dire des éléments et composants déjà qualifiés. C'est ainsi que dans l'exemple de la figure 2, des essais ont été effectués notamment avec une colle électriquement conductrice portant la référence ECF564A, livré dans la forme d'un film de 125µ d'épaisseur. Cette colle était ensuite polymérisée a 150 °C pendant quelques heures, suivant le mode d'emploi du fabricant de la colle. Il est évident que le choix de la colle à utiliser sera laissé à l'homme du métier, sans sortir pour autant du cadre de l'invention. Par exemple, une colle thermiquement conductrice ou thermiquement et électriquement conductrice pourrait être préférée pour certaines applications.

La Déposante a également utilisé lors des essais, pour les feuilles de matériau souples (15) et (14), ce dernier formant la paroi souple refermant la région étanche à évacuer, un film nylon qui résiste à la température d'étuvage, portant la référence "Capran 980", une matière facilement disponible dans le commerce. Toute autre matière ayant les propriétés voulues pourrait être substituée à ce choix, bien entendu. Un feutre polyester spécifiquement conçu pour remplir la mission d'évacuation comporte le nom commercial et référencé "Airbleed 100", mais des équivalents sont disponibles.

Dans une variante préférée du procédé de l'invention, la table rigide (12) est de la même matière que le support (10). Des essais satisfaisants ont été effectués par la Déposante utilisant l'alliage "Dilver" pour ces deux éléments. Cette solution procure des avantages évidents en cas d'étuvage avec des excursions importantes de température lors des procédés de fabrication.

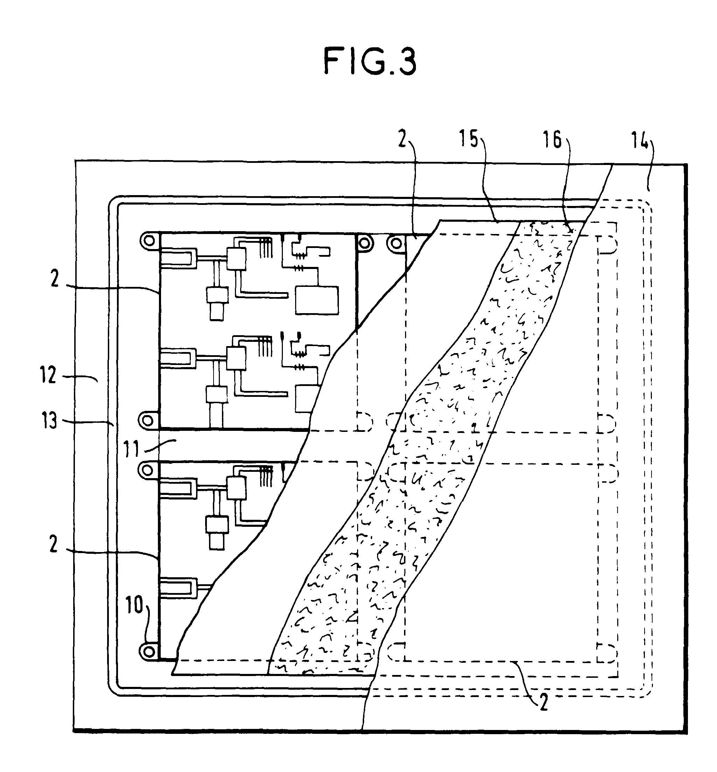

Sur la figure 3, l'on voit que le procédé selon l'invention est facilement adapté pour effectuer plusieurs assemblages simultanément. En choisissant les dimensions latérales de la table rigide (12) et de la feuille souple (14) plus grandes qu'un multiple des dimensions des pièces à assembler tel que montré sur cette figure, il est possible de traiter x assemblages, identiques ou non, au même temps, d'ou un gain considérable sur la rentabilité de l'opération. Sur cette figure, l'on voit quatre circuits hybrides sur substrats rigides (2) de grandes dimensions, placés sur quatre supports métalliques (10), placés l'un à côté des autres sur la table rigide (12) à l'intérieur du joint (13). Le tout est ensuite recouvert par la feuille de matériau souple (15) pour éviter de débordements de colle (11), et un feutre (16) pour aider dans l'évacuation de l'air de l'intérieur de la première région étanche qui est d'abord fermée par la feuille (14) souple et imperméable à l'air. Mise à part les plus grandes dimensions de l'outillage, tout se passe comme dans l'exemple précédent de la figure 2. Des essais ont été effectués par la Déposante jusqu'à huit paires de pièces assemblées simultanément, et ces essais laissent supposer que le procédé pourrait facilement être dimensionné pour en traiter au moins le double de ce nombre sans problème particulier.

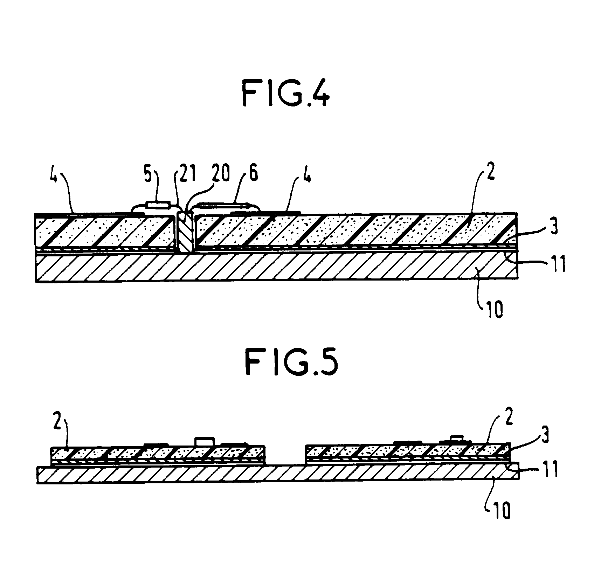

Sur la figure 4, schématiquement et en coupe, l'on voit en coupe un exemple d'un dispositif d'assemblage d'un circuit hybride sur substrat rigide (2) fixé par sa face métallisée (3) sur un support métallique (10) par une couche de colle (11) suivant un procédé de l'invention. Cette figure 4 fait apparaître un autre variante de l'invention, qui prévoit d'appliquer le même procédé industriel pour réaliser des retours à la masse à travers le substrat, en même temps que la réalisation du collage du substrat sur son support. Pour ce faire, des petits plots conducteurs (20) sont insérés dans des trous pratiqués à travers le substrat.

Les plots sont de dimensions en largeur légèrement inférieures au diamètre des trous, mais égaux en hauteur à l'épaisseur du substrat (2). Avantageusement, les plots (20) sont réalisés de la même matière que le support (10), éventuellement doré pour la conductivité électrique. Ces plots remplissent les mêmes fonction que des trous métallisés dans un circuit classique, mais permettent de s'affranchir de l'étape de fabrication nécessaire à la réalisation des trous métallisé. Comme montré sur la figure 4, des composants actifs (5) ou passifs (6) peuvent être ainsi reliés à la masse en les connectant à l'extrémité libre d'un tel plot par des pattes (21) du composant.

La figure 5 montre une variante d'un dispositif réalisé selon le procédé de l'invention. Cette variante comporte deux circuits sur deux substrats rigides (2), collés par leurs faces métallisées (3) sur une seule face d'un seul support (10) moyennant deux films de colle (11).

Les quelques exemples du procédé selon l'invention énumérés ci-dessus, ainsi que les quelques exemples de dispositifs réalisés selon ce procédé, ont fait comprendre la simplicité de la mise en oeuvre du procédé, d'une part, et les économies qui peuvent être réalisées dans une fabrication industrielle selon un tel procédé. De plus, les tailles de circuits hybrides qui peuvent être assemblés selon ces méthodes sont d'au moins deux fois plus grandes que celles réalisables dans l'art antérieur, d'ou un gain considérable de poids et d'encombrement des équipements utilisant plusieurs circuits.

Enfin, les performances des assemblages ainsi réalisés dépassent celles de l'art antérieur par une confortable marge, car des essais en vibrations et chocs effectués par la Demanderesse ont démontré la très grande robustesse de cette solution. Tout porte à croire que, à l'avenir, le collage sous vide remplacera la brasure dure totalement pour l'assemblage des circuits hybrides sur support rigide, d'abord pour les domaines spatiaux et militaires, mais à terme, pour toutes applications de circuits hybrides.

## Revendications

1. Procédé d'assemblage d'au moins deux pièces, la première pièce étant un substrat rigide (2) d'un circuit électronique hybride, la deuxième pièce étant une pièce métallique (10), chaque pièce à assembler ayant au moins une surface sensiblement plane, lesdites pièces étant collés par la polymérisation d'un film de colle (11) placé entre une surface plane de ladite première pièce et une surface plane de ladite deuxième pièce à assembler, ladite polymérisation étant effectuée sous une pression mécanique exercée sur ces pièces dans une direction normale à ladite surface plane de chaque pièce, ledit procédé étant caractérisé en ce que lesdits pièces à assembler sont placés sur une surface rigide (12) ayant des dimensions plus grandes que les dimensions des pièces à assembler, ladite surface rigide ayant un pourtour et ce pourtour comportant un joint d'étanchéité (13); et en ce que lesdites pièces à assembler sont ensuite recouvertes d'une feuille d'un matériau souple (14) et imperméable à l'air, ladite feuille étant placée en contact avec ledit joint d'étanchéité de façon à former avec ladite surface rigide une première région entre ladite feuille et ladite surface, cette première région contenant les pièces à assembler étant ainsi séparée de façon étanche d'une deuxième région en dehors de ladite première région et contenant entièrement cette première région ; et en ce que ladite première région est ensuite au moins partiellement évacuée à l'aide d'une pompe à vide mise en communication avec l'intérieur de ladite première région par une canalisation étanche.

2. Procédé selon la revendication 1, caractérisé en ce que ledit substrat rigide (2) est métallisé sur au moins l'une (3) de ses deux faces, et en ce que ledit film de colle (11) est placé en contact avec une face métallisée dudit substrat.

3. Procédé selon l'une des revendications quelconque 1 à 2, caractérisé en ce que ladite pièce métallique (10) a un coefficient de dilatation thermique voisin de celui dudit substrat rigide.

4. Procédé selon l'une des revendications quelconque 1 à 3, caractérisé en ce que ledit substrat (2) est du Al₂O₃.

5. Procédé selon l'une des revendications quelconque 1 à 4, caractérisé en ce que ladite pièce métallique (10) est de l'alliage connu sous le nom de commerce "Dilver".

6. Procédé selon la revendication 1, caractérisé en ce que ladite surface rigide (12) est de la même matière que ladite pièce métallique (10).

7. Procédé selon l'une quelconque des revendications 1 à 6, caractérisé en ce que ladite colle (11) est une colle thermiquement conductrice.

8. Procédé selon l'une quelconque des revendications 1 à 7, caractérisé en ce que ladite colle (11) est une colle électriquement conductrice.

9. Procédé selon l'une quelconque des revendications 1 à 6, caractérisé en ce que ladite colle (11) est une colle électriquement et thermiquement conductrice.

10. Procédé selon l'une quelconque des revendications 8 à 9, caractérisé en ce que ledit substrat rigide (2) comporte un ou plusieurs trous qui le traversent ; ces trous ayant des dimensions d'étendue dans le plan dudit substrat, et de profondeur dans une direction perpendiculaire à ce dit plan correspondant à l'épaisseur dudit substrat ; et en ce que des plots métalliques (20) de la même matière que ladite deuxième pièce métallique sont insérés dans ces trous , ces plots ayant des dimensions d'étendue inférieures aux dimensions desdits trous dans le plan du substrat (2), et égale à la profondeur desdits trous ; et en ce que lesdits plots (20) sont collés dans lesdits trous de façon à réaliser un chemin électriquement conducteur qui traverse ledit substrat.

11. Procédé selon l'une quelconque des revendications 1 à 10, caractérisé en ce que ledit film de colle (11) comprend une trame relativement incompressible d'une autre matière, de façon à tenir les deux pièces à assembler à une distance minimale l'une de l'autre même avec une forte différentiel de pression.

12. Procédé selon la revendication 11, caractérisé en ce que ledit film de colle (11) comprend un tissus de fibres de verre qui rend ledit film de colle relativement incompressible au-delà d'une certaine limite minimale d'épaisseur.

13. Procédé selon la revendication 12, caractérisé en ce que ledit film de colle (11) est formé par l'imprégnation d'un tissu de fibre de verre avec une colle appropriée.

14. Procédé selon l'une quelconque des revendications 1 à 13, caractérisé en ce que ladite surface rigide (12) d'assemblage à des dimensions qui sont plus grandes qu'un multiple des dimensions des pièces (2, 10) à assembler, de façon à pouvoir mettre plusieurs paires de pièces à assembler sur ladite surface rigide pour effectuer le collage sous vide de plusieurs assemblages simultanément.

## Patentansprüche

1. Verfahren zum Zusammenbau mindestens zweier Bauteile, von denen das erste ein starres Substrat (2) mit einer elektronischen hybriden Schaltung und das zweite ein metallisches Bauteil (10) ist, wobei beide Bauteile mindestens je eine im wesentlichen ebene Fläche besitzen und durch Polymerisierung eines Klebstofffilms (11) verklebt werden, der zwischen einer ebenen Fläche des ersten Bauteils und einer ebenen Fläche des zweiten Bauteils angeordnet wird, wobei die Polymerisierung unter einem mechanischen Druck erfolgt, der auf diese Bauteile in einer Richtung senkrecht zu der ebenen Oberfläche jedes Bauteils wirksam wird, dadurch gekennzeichnet, daß die zusammenzubauenden Bauteile auf einer starren Oberfläche (12) mit größeren Abmessungen als die der zusammenzubauenden Bauteile angeordnet werden, wobei die starre Oberfläche einen Umfang und dieser Umfang eine Dichtung (13) besitzt, und daß die zusammenzubauenden Bauteile dann mit einer Folie (14) eines nachgiebigen und luftundurchlässigen Materials bedeckt werden, die in Kontakt mit der Dichtung gebracht wird, so daß die Folie mit der starren Oberfläche eine erste Zone zwischen der Folie und dieser Oberfläche bildet, die die zusammenzubauenden Bauteile enthält, daß diese erste Zone mit den zusammenzubauenden Bauteilen dicht gegenüber einer zweiten, die erste Zone ganz enthaltenden Zone außerhalb der ersten Zone getrennt ist, und daß die erste Zone dann zumindest teilweise mit Hilfe einer Vakuumpumpe evakuiert wird, die mit dem Innenraum der ersten Zone durch eine dichte Kanalisation in Verbindung gebracht wird.

2. Verfahren nach Anspruch 1, dadurch gekennzeichnet, daß das starre Substrat (2) auf mindestens einer seiner beiden Seiten eine Metallbeschichtung (3) trägt, und daß der Klebstofffilm (11) mit einer metallbeschichteten Seite des Substrats in Kontakt gebracht wird.

3. Verfahren nach einem beliebigen der Ansprüche 1 und 2, dadurch gekennzeichnet, daß das metallische Bauteil (10) einen Wärmeausdehnungskoeffizienten ähnlich dem des starren Substrats besitzt.

4. Verfahren nach einem beliebigen der Ansprüche 1 bis 3, dadurch gekennzeichnet, daß das Substrat (2) aus Al₂O₃ ist.

5. Verfahren nach einem beliebigen der Ansprüche 1 bis 4, dadurch gekennzeichnet, daß das metallische Bauteil (10) aus einer unter dem Handelsnamen "Dilver" bekannten Legierung ist.

6. Verfahren nach Anspruch 1, dadurch gekennzeichnet, daß die starre Oberfläche (12) aus dem gleichen Material wie das metallische Bauteil (10) ist.

7. Verfahren nach einem beliebigen der Ansprüche 1 bis 6, dadurch gekennzeichnet, daß der Klebstoff (11) ein thermisch leitender Klebstoff ist.

8. Verfahren nach einem beliebigen der Ansprüche 1 bis 7, dadurch gekennzeichnet, daß der Klebstoff (11) ein elektrisch leitender Klebstoff ist.

9. Verfahren nach einem beliebigen der Ansprüche 1 bis 6, dadurch gekennzeichnet, daß der Klebstoff (11) ein elektrisch und thermisch leitender Klebstoff ist.

10. Verfahren nach einem beliebigen der Ansprüche 8 und 9, dadurch gekennzeichnet, daß das starre Substrat (2) eines oder mehrere das Substrat durchquerende Löcher aufweist, deren Breite in der Ebene des Substrats und deren Länge entsprechend der Dicke des Substrats in einer Richtung senkrecht zur Ebene des Substrats gemessen werden, und daß metallische Durchführungen (20) aus dem gleichen Material wie das zweite metallische Bauteil in diese Löcher gesteckt werden, deren Breite kleiner als die Abmessungen der Löcher in der Ebene des Substrats (2) und deren Länge gleich der Tiefe der Löcher ist, und daß die Durchführungen (20) in die Löcher geklebt werden, so daß sie einen elektrisch leitenden Weg durch das Substrat hindurch bilden.

11. Verfahren nach einem beliebigen der Ansprüche 1 bis 10, dadurch gekennzeichnet, daß der Klebstofffilm (11) eine relativ wenig komprimierbare Struktur aus einem anderen Material besitzt, so daß er die beiden zusammenzubauenden Bauteile selbst bei einem hohen aufgewendeten Druck auf einem gegenseitigen Mindestabstand hält.

12. Verfahren nach Anspruch 11, dadurch gekennzeichnet, daß der Klebstofffilm (11) ein Glasfasergewebe enthält, das den Klebstofffilm verhältnismäßig ab einer bestimmten Mindestdicke wenig komprimierbar macht.

13. Verfahren nach Anspruch 12, dadurch gekennzeichnet, daß der Klebstofffilm (11) durch Imprägnierung eines Glasfasergewebes mit einem geeigneten Klebstoff gebildet wird.

14. Verfahren nach einem beliebigen der Ansprüche 1 bis 13, dadurch gekennzeichnet, daß die starre Oberfläche (12) für den Zusammenbau Abmessungen besitzt, die größer als ein Vielfaches der Abmessungen der zusammenzubauenden Bauteile (2, 10) sind, so daß mehrere Paare von zusammenzubauenden Bauteilen auf der starren Oberfläche angeordnet werden können, um gleichzeitig mehrere Paare von Bauteilen bei Unterdruck miteinander zu verkleben.

## Claims

1. A method of assembling together at least two parts, the first part being a rigid substrate (2) of a hybrid electronic circuit, the second part being a metal part (10), each of the parts to be assembled together having at least one substantially plane surface, said parts being glued together by polymerizing a film of glue (11) placed between a plane surface of said first part and a plane surface of said second part, said polymerization being performed under mechanical pressure exerted on the parts in a direction normal to said plane surface of each part, said method being characterized in that said parts to be assembled together are placed on a rigid surface (12) having dimensions that are larger than the dimensions of the parts to be assembled together, said rigid surface having a periphery, and the periphery including a sealing gasket (13); and in that said parts to be assembled together are then covered with a sheet of flexible material (14) that is airtight, said sheet being placed in contact with said sealing gasket so as to co-operate with said rigid surface to form a first region between said sheet and said surface, the first region containing the parts to be assembled together thus being separated in airtight manner from a second region outside said first region, with the first region being entirely contained therein; and in that said first region is then at least partially evacuated by means of a vacuum pump communicating with the inside of said first region via an airtight pipe.

2. A method according to claim 1, characterized in that at least one of the two faces (3) of said rigid substrate (2) is metal-plated, and in that said film of glue (11) is placed in contact with a metal-plated face of said substrate.

3. A method according to claim 1 or 2, characterized in that said metal part (10) has a coefficient of thermal expansion close to the coefficient of thermal expansion of said rigid substrate.

4. A method according to any one of claims 1 to 3, characterized in that said substrate (2) is Al₂O₃.

5. A method according to any one of claims 1 to 4, characterized in that said metal part (10) is made of the alloy known under the trade name "Dilver".

6. A method according to claim 1, characterized in that said rigid surface (12) is made of the same material as said metal part (10).

7. A method according to any one of claims 1 to 6, characterized in that said glue (11) is a thermally conductive glue.

8. A method according to any one of claims 1 to 7, characterized in that said glue (11) is an electrically conductive glue.

9. A method according to any one of claims 1 to 6, characterized in that said glue (11) is a glue that is both electrically and thermally conductive.

10. A method according to claim 8 or 9, characterized in that said rigid substrate (2) is provided with one or more through holes; the holes having transverse dimensions in the plane of said substrate, and depth dimensions in a direction perpendicular to said plane and corresponding to the thickness of said substrate; and in that metal pins (20) made of the same material as said metal second part are inserted into the holes, the pins having transverse dimensions smaller than the dimensions of said holes in the plane of said substrate (2), and depth dimensions equal to the depth of said holes; and in that said pins (20) are glued in said holes so as to provide an electrically-conductive path through said substrate.

11. A method according to any one of claims 1 to 10, characterized in that said film (11) of glue includes a relatively-incompressible screen made of another material so as to keep the two parts to be assembled together at a minimum distance from each other even when there is a high pressure differential.

12. A method according to claim 11, characterized in that said film of glue (11) includes a glass-fiber fabric which makes the film of glue relatively incompressible beyond a certain minimum thickness limit.

13. A method according to claim 12, characterized in that said film of glue (11) is formed by impregnating a glass-fiber fabric with a suitable glue.

14. A method according to any one of claims 1 to 13, characterized in that said rigid assembly surface (12) has dimensions that are greater than a multiple of the dimensions of the parts (2, 10) to be assembled together, so that a plurality of pairs of parts to be assembled together can be put on said rigid surface in order to vacuum glue a plurality of assemblies simultaneously.
